# EUROPEAN PATENT APPLICATION

(11) **EP 4 716 391 A1**
(43) Date of publication of application: **25.03.2026**
(21) Application number: 24857904.7
(22) Date of filing: 31.05.2024
(51) Int. Cl.: H05K 7/20

(54) **HEAT CONDUCTION PAD AND ELECTRONIC DEVICE**

(30) Priority: 25.08.2023 CN 202311086548
(71) Applicant: Shenzhen Yinwang Intelligent Technologies Co., Ltd., Shenzhen, Guangdong 518110 (CN)
(72) Inventor: PENG, Yaofeng, Shenzhen, Guangdong 518129 (CN)
(74) Representative: Körber, Martin Hans
(86) International application number: PCT/CN2024/096853
(87) International publication number: WO 2025/044359

(57) **Abstract**

A thermal pad and an electronic device are disclosed, and relate to the field of heat dissipation technologies, to effectively dissipate heat of an electronic component. The thermal pad includes a first cover, a second cover, an elastic shell, and liquid metal. The elastic shell is bent and closed into a tubular structure. The first cover and the second cover are respectively mounted at two ends of the tubular structure to form a closed cavity. The closed cavity is configured to accommodate the liquid metal. Filling the liquid metal into the elastic shell not only implements good heat conduction effect by using high thermal conductivity of the liquid metal, but also implements compression on the thermal pad during assembly of the thermal pad by using compressibility of the elastic shell, to reduce a thickness of the thermal pad as much as possible. This reduces thermal resistance of the thermal pad, and further improves heat conduction effect of the thermal pad, thereby helping effectively dissipate heat of the electronic component.

## Description

### CROSS-REFERENCE TO RELATED APPLICATIONS

This application claims priority to Chinese Patent Application No. 202311086548.8, filed with the China National Intellectual Property Administration on August 25, 2023 and entitled "THERMAL PAD AND ELECTRONIC DEVICE", which is incorporated herein by reference in its entirety.

### TECHNICAL FIELD

This application relates to the field of heat dissipation technologies, and in particular, to a thermal pad and an electronic device.

### BACKGROUND

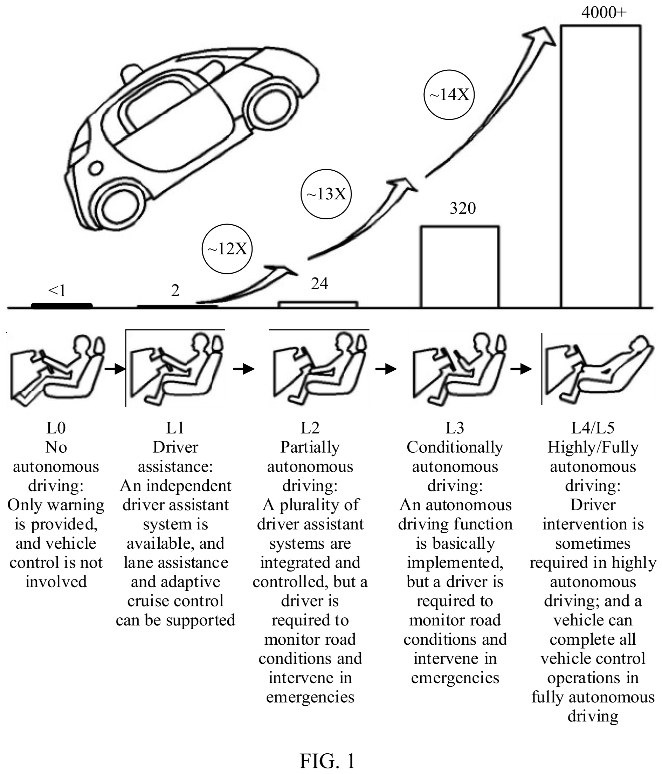

In recent years, with further development of autonomous driving technologies, requirements of vehicles for computing power of vehicle-mounted chips continuously increase accordingly. According to related research, each time the autonomous driving technology improves by one level, the required computing power increases exponentially. For example, refer to FIG. 1. From an L1 level of autonomous driving, each subsequent level requires approximately 12 to 14 times more computing power than the previous level. Especially in L4-level highly autonomous driving or L5-level fully autonomous driving, a quantity of tera floating-point operations per second (tera floating-point operations per second, TFLOPS) or a quantity of tera operations per second (tera operations per second, TOPS) that the vehicle-mounted chip performs reaches more than 4000. With such a rapid growth rate of the computing power, heat consumption of the vehicle-mounted chip sharply increases accordingly. How to quickly dissipate heat of a vehicle-mounted chip with high computing power becomes a technical difficulty that affects further development of the autonomous driving technology.

Currently, a thermal pad may be used to dissipate heat of the vehicle-mounted chip. However, an existing thermal pad is usually made of materials such as a metal oxide or silicone gel, and thermal conductivity of these materials is not good. Especially, under the influence of a manufacturing tolerance of an existing device, a thickness of the thermal pad needs to be set to 1 mm to 2 mm. Such a thick thermal pad results in very large thermal resistance, and cannot effectively dissipate heat of the vehicle-mounted chip.

In conclusion, how to effectively dissipate heat of an electronic component (for example, a chip) is a technical problem that urgently needs to be resolved in development of an electronic component with high computing power.

### SUMMARY

This application provides a thermal pad and an electronic device, to effectively dissipate heat of an electronic component.

According to a first aspect, this application provides a thermal pad. The thermal pad includes a first cover, a second cover, an elastic shell, and liquid metal. The elastic shell is bent and closed into a tubular structure, and the first cover and the second cover are respectively mounted at two ends of the tubular structure to form a closed cavity. The closed cavity is configured to accommodate the liquid metal.

In the foregoing design, filling the liquid metal into the elastic shell can not only implement good heat conduction effect by using high thermal conductivity of the liquid metal, but also implement compression on the thermal pad during assembly of the thermal pad by using compressibility of the elastic shell, to reduce a thickness of the thermal pad as much as possible. This reduces thermal resistance of the thermal pad and further improves heat conduction effect of the thermal pad, thereby helping effectively dissipate heat of the electronic component.

In a possible design, the first cover and the second cover may be metal covers. The metal cover may be made of a metal material with good thermal conductivity, for example, a copper cover, an aluminum cover, a silver cover, or a gold cover.

In the foregoing design, the metal cover is used, so that heat of a component located outside the first cover (or the second cover) can be better transferred to the liquid metal, and heat of the liquid metal can also be better transferred to a component outside the second cover (or the first cover). This helps implement rapid heat conduction between the component outside the first cover and the component outside the second cover.

In a possible design, the elastic shell may be made of an elastic material. The elastic material may be, for example, beryllium copper, phosphor copper, thin steel, or rubber. The elastic material enables the elastic shell to have a deformation capability, to help compress the thermal pad.

In a possible design, when a thickness of the elastic shell is less than a first thickness, the thermal pad may further include an elastic structure. The elastic structure is connected between the first cover and the second cover.

According to the foregoing design, when the thickness of the elastic shell is excessively small and an electronic device cannot be tightly pressed by using a rebound force of the elastic shell, the elastic structure may be further disposed, so that a rebound force provided by the elastic structure and a rebound force provided by the elastic shell are jointly applied to an electronic component, to tightly press the electronic component. In this way, effective contact is formed between the electronic component and the thermal pad, to implement effective heat transfer.

In a possible design, the thermal pad is compressed between the heat sink and the electronic component, and pressure applied by the thermal pad to the electronic component is not less than minimum tolerable pressure of the electronic component and is not greater than maximum tolerable pressure of the electronic component.

According to the foregoing design, when the thermal pad is compressed to reduce thermal resistance, a force requirement of the electronic component can be met, to avoid damaging the electronic component.

In a possible design, when the thermal pad is compressed between the heat sink and the electronic component, a thickness of the elastic shell is less than a first thickness, and the first thickness is an initial thickness of the thermal pad upon preparation. In this way, the elastic shell may be used to compress the thermal pad by using a deformation capability of the elastic shell.

In a possible design, the thermal pad may further include a mouse-tail tube. The mouse-tail tube is internally hollow and penetrates the first cover or the second cover. One end of the mouse-tail tube extends into the closed cavity, and the other end of the mouse-tail tube is sealed after the liquid metal is guided into the closed cavity. The mouse-tail tube may be integrally formed with the cover penetrated by the mouse-tail tube, to simplify a preparation process.

In a further possible design, the elastic shell bulges outward. For example, in a process of filling the liquid metal through the mouse-tail tube, filling is stopped until the elastic shell bulges outward, to ensure that the liquid metal fills up the entire closed cavity, and the filled liquid metal is used to connect the first cover to the second cover.

According to a second aspect, this application provides a heat dissipation apparatus, including a heat sink, an electronic component, and the thermal pad according to any design of the first aspect. The thermal pad is compressed between the heat sink and the electronic component, and a rebound force of the elastic shell is used to press the first cover toward the heat sink and press the second cover toward the electronic component.

In the foregoing design, the thermal pad is compressed between the heat sink and the electronic component. Even if a gap between the electronic component and the heat sink is large due to a deviation of an existing preparation process, the gap may be reduced by compressing the elastic shell, to reduce a thickness of the thermal pad, reduce thermal resistance of the thermal pad, and improve heat conduction effect of the thermal pad. This further improves heat dissipation effect on the electronic component.

In a possible design, the heat dissipation apparatus may further include a first heat dissipation layer. The first heat dissipation layer is disposed between the first cover and the heat sink, and is configured to implement heat dissipation from the first cover to the heat sink.

In a further possible design, the first heat dissipation layer may be made of a heat conducting phase change material, thermal gel, solder paste, silicone grease, or be another type of ultra-thin thermal pad. In this way, the first heat dissipation layer is designed as the heat conducting phase change material, thermal gel, or solder paste with good thermal conductivity, to improve heat conduction effect of the first heat dissipation layer. Alternatively, the first heat dissipation layer is designed as the silicone grease or ultra-thin thermal pad with poor thermal conductivity but an ultra-thin thickness, to reduce thermal resistance of the first heat dissipation layer and improve heat dissipation effect from the first cover to the heat sink.

In a possible design, the heat dissipation apparatus may further include a second heat dissipation layer. The second heat dissipation layer is disposed between the second cover and the electronic component, and is configured to implement heat dissipation from the electronic component to the second cover.

In a further possible design, the second heat dissipation layer may be made of silicone grease, a heat conducting phase change material, or thermal gel. In this way, the second heat dissipation layer is designed as a non-metal material with good heat conduction or heat dissipation, to reduce thermal resistance of the second heat dissipation layer, improve heat transfer effect from the electronic component to the second cover, and avoid use of a metal heat dissipation material, to reduce a risk of interference to the electronic component.

In a possible design, the heat dissipation apparatus may further include a circuit board. The circuit board is configured to carry the electronic component, to support and fasten the electronic component.

In a further possible design, the circuit board may be fastened to the heat sink through a screw, to clamp the electronic component and the thermal pad between the circuit board and the heat sink, so as to avoid movement.

According to a third aspect, this application provides an electronic device, including the heat dissipation apparatus according to any design of the second aspect. The electronic device may be a vehicle-mounted device, a terminal device, a network device, a computing device, an industrial device, a smart home device, or the like.

Implementations and beneficial effect of the first aspect to the third aspect are specifically described in the following embodiments.

### BRIEF DESCRIPTION OF DRAWINGS

FIG. 1 illustrates a correspondence between an autonomous driving level and a computing power requirement;
FIG. 2 illustrates a possible application scenario of a thermal pad according to this application;
FIG. 3 illustrates a structure of a thermal pad according to this application;
FIG. 4 illustrates a preparation process of a thermal pad according to this application;
FIG. 5 illustrates an assembly manner of a thermal pad according to this application;
FIG. 6 illustrates a structure of another thermal pad according to this application;
FIG. 7 illustrates a structure of a heat dissipation apparatus according to this application;
FIG. 8 illustrates a structure of a liquid-cooled heat sink according to this application;
FIG. 9 illustrates an assembly process of a heat dissipation apparatus according to this application;
FIG. 10 illustrates a structure of a circuit board on which a plurality of electronic components are integrated according to this application;
FIG. 11 illustrates a flowchart of evolution of an in-vehicle electrical/electronic architecture according to this application;
FIG. 12 illustrates a possible functional framework of a processor according to this application; and
FIG. 13 illustrates a functional framework of an electronic device according to this application.

### DESCRIPTION OF EMBODIMENTS

The following describes possible application scenarios of this application.

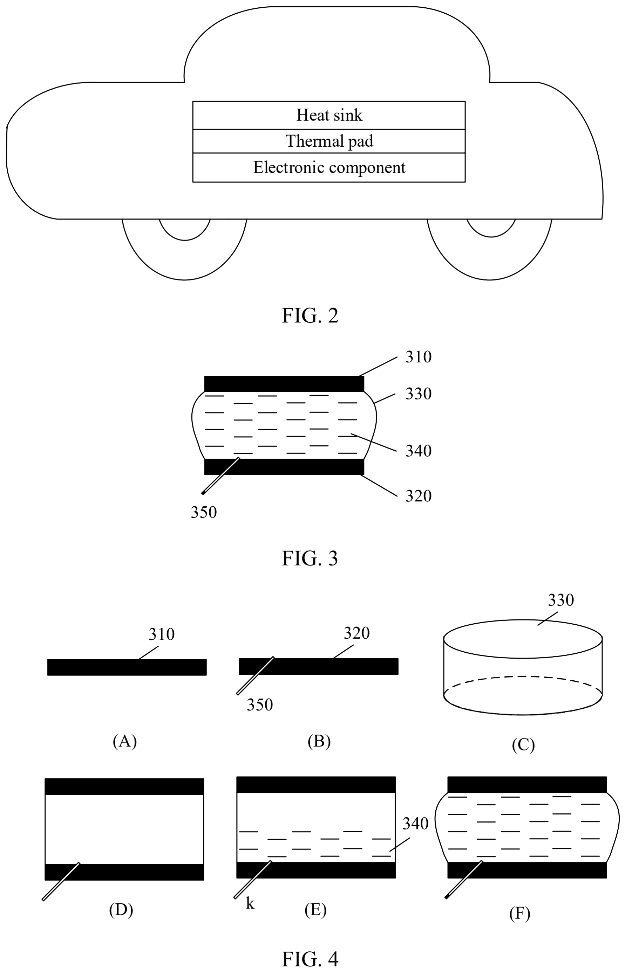

In a possible application scenario, a thermal pad in this application may be used in a means of transportation. The means of transportation may be, for example, a vehicle, a ship, an airplane, a high-speed railway, an uncrewed aerial vehicle, a submarine, or a subway. For example, as shown in FIG. 2, an example in which the thermal pad is used in a vehicle is used. The thermal pad may be used in cooperation with any electronic component in the vehicle. For example, the thermal pad may be connected between an electronic component and a heat sink, and is configured to conduct heat of the electronic component to the heat sink, to dissipate heat of the electronic component.

For example, the foregoing application scenarios may be applied to fields such as unmanned driving, autonomous driving, assisted driving, intelligent driving, networked vehicles, security surveillance, biomedical, or surveying and mapping (for example, three-dimensional drawing). For example, in autonomous driving, the thermal pad may be used in cooperation with an electronic component related to autonomous driving in the vehicle, for example, an autonomous driving chip or an autonomous driving system-on-chip (system-on-chip, SOC), to adapt to an autonomous driving function with gradually increasing computing power through fast and effective heat dissipation.

It should be understood that the foregoing application scenario is merely an example. The thermal pad provided in this application may be further used in another possible scenario, and is not limited to the scenario in the foregoing example. For example, the thermal pad may alternatively be used in a terminal device, and is used as a thermally conductive member of a chip or another electronic component in the terminal device, to dissipate heat of the terminal device. For another example, the thermal pad may alternatively be used in a computing device, so that the computing device is always at a most appropriate operating temperature, to maintain stability of a computing capability. For another example, the thermal pad may alternatively be used in a network device, and is used as a thermally conductive member of an apparatus like a switch, a base station, or a gateway, to implement stability of interaction between the apparatus and another apparatus. For another example, the thermal pad may alternatively be used in an industrial device, to implement controllability of a temperature of the industrial device in a long-time working state. For another example, the thermal pad may alternatively be used in a smart home device, to maintain safety of a user living environment. Another example is not described. Examples are not enumerated herein.

It should be noted that the application scenarios described in this application are intended to describe the technical solutions in this application more clearly, and do not constitute a limitation on the technical solutions provided in this application.

As described in the background, an existing thermal pad is usually made of a non-metallic material, and thermal conductivity of the existing thermal pad cannot be ensured. In view of this, this application provides a thermal pad, and liquid metal is filled in an elastic shell, to implement good heat conduction effect by using high thermal conductivity of the liquid metal.

It should be noted that wrapping the liquid metal in the elastic shell for heat conduction is only a part of inventive points of this application. This application is further used to compress the thermal pad wrapped with liquid metal when the thermal pad is assembled between a heat sink and an electronic component, so that a thickness of the thermal pad is reduced, thereby effectively reducing thermal resistance of the thermal pad by using a positive correlation relationship between the thickness and the thermal resistance, and further improving thermal conductivity of the thermal pad. Although some existing thermal pads use beryllium copper (an elastic material) to encapsulate water and a capillary core for cooling, which seems similar to this application, the capillary core is rigid, and the existing thermal pad cannot be compressed. In other words, a thickness of the thermal pad can only be maintained at an initial thickness upon preparation, or may be slightly smaller than the initial thickness. In comparison with the conventional technology, this application not only replaces a thermally conductive material in the elastic shell, but also uses an elastic compression capability of the elastic shell to reduce the thickness of the thermal pad during assembly, so as to further improve heat conduction effect.

Based on the foregoing content, the following describes embodiments of this application in detail with reference to FIG. 3 to FIG. 11.

FIG. 3 is a diagram of a structure of a thermal pad according to this application. The thermal pad includes a first cover 310, a second cover 320, an elastic shell 330, and liquid metal 340. The elastic shell 330 is bent and closed into a tubular structure, and the first cover 310 and the second cover 320 are respectively mounted at two ends of the tubular structure to form a closed cavity. The closed cavity is configured to accommodate the liquid metal 340.

For example, still refer to FIG. 3. The thermal pad may further include a mouse-tail tube 350. The mouse-tail tube 350 is internally hollow and penetrates the first cover 310 or the second cover 320 (an example in which the mouse-tail tube 350 penetrates the second cover 320 is used in the figure). One end of the mouse-tail tube 350 extends into the closed cavity, and the other end of the mouse-tail tube 350 is sealed after the liquid metal 340 is filled into the closed cavity.

Optionally, for example, the mouse-tail tube 350 penetrates the second cover 320. FIG. 4 illustrates a preparation process of a thermal pad according to this application. The preparation process mainly includes the following steps.

Step 1: As shown in (A) in FIG. 4, the first cover 310 is cast.

Step 2: As shown in (B) in FIG. 4, the second cover 320 and the mouse-tail tube 350 that are integrally formed are cast, and two ends of the mouse-tail tube 350 are connected to each other.

Step 3: As shown in (C) in FIG. 4, the elastic shell 330 is bent into a tubular structure.

It may be understood that (C) in FIG. 4 shows an example in which the elastic shell 330 is bent into a round tube. However, it should be understood that the elastic shell 330 may alternatively be bent into a tube of any other shape, for example, an elliptical tube, a square tube, a rectangular tube, another polygonal tube, a special-shaped tube, or a spliced tube including at least two tubes.

Step 4: As shown in (D) in FIG. 4, the first cover 310 is mounted at one end of the elastic shell 330, and the second cover 320 is mounted at the other end of the elastic shell 330, to form a closed cavity.

Step 5: As shown in (E) in FIG. 4, the liquid metal 340 is filled into the closed cavity through the other end (end k) of the mouse-tail tube 350.

Step 6: As shown in (F) in FIG. 4, after it is determined that the closed cavity is filled up with the liquid metal 340, the end k of the mouse-tail tube is sealed. A sealing manner may include but is not limited to soldering, squeezing, pasting, sealing by using a sealing strip, clamping through a clamping groove, snap-fitting, or the like.

It may be understood that in step 6, because the elastic shell 330 is opaque, to ensure that the entire closed cavity is filled up with the liquid metal 340, filling may be stopped when the elastic shell 330 slightly bulges after the liquid metal 340 is filled into the mouse-tail tube 350. In this case, the elastic shell 330 is presented as a tubular structure bulging outward, for example, a bulging cylinder shown in FIG. 3 or FIG. 4.

The following separately describes the components in FIG. 3 or FIG. 4, to provide an example of a specific implementation solution.

### 1. First cover and second cover

In an optional implementation, the first cover 310 and the second cover 320 may be set as metal covers. The metal cover may be considered as being made of a metal material with good thermal conductivity, for example, a copper cover, an aluminum cover, a silver cover, or a gold cover. The metal cover can transfer heat of a component located outside the first cover 310 (or the second cover 320) to the liquid metal, and can also transfer heat of the liquid metal to a component located outside the second cover 320 (or the first cover 310), to help implement effective heat conduction between the first cover 310 and the second cover 320.

In a further implementation, the first cover 310 and the second cover 320 may be metal covers made of a same material, or may be metal covers made of different materials. For example, in an example, to reduce costs of the thermal pad, the first cover 310 and the second cover 320 may be both set as copper covers.

In an optional implementation, the first cover 310 and the second cover 320 are respectively mounted at two ends of the tubular structure, and it may be understood that the first cover 310 is sealed and fastened to one end (for example, an upper side edge in the figure) of the elastic shell 330, and the second cover 320 is sealed and fastened to the other end (for example, a lower side edge in the figure) of the elastic shell 330. A sealing and fastening manner may include but is not limited to soldering, pasting (using an adhesive or an adhesive tape), sealing through a sealing strip, clamping through a clamping groove, fastening, snap-fitting, or the like. This is not specifically limited.

### 2. Elastic shell

It may be understood that the elastic shell 330 may be made of an elastic material. The elastic material may include, but is not limited to, beryllium copper, phosphor copper, thin steel, rubber, or the like. Optionally, as beryllium copper has advantages such as high thermal conductivity, corrosion resistance, cold resistance, and wear resistance, the elastic shell 330 may be made of beryllium copper.

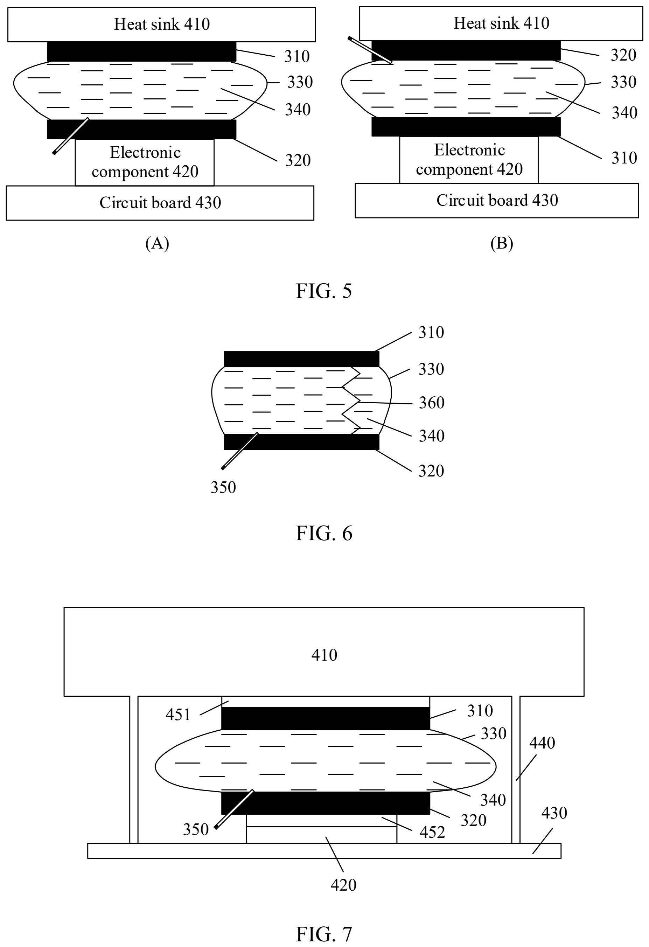

In an optional implementation, as shown in FIG. 5, when the thermal pad is used, the elastic shell 330 may be compressed between a heat sink 410 and an electronic component 420, and the electronic component 420 is usually disposed on a circuit board 430. In other words, compared with the elastic shell 330 in an initial state shown in FIG. 3, the elastic shell 330 in a used state shown in FIG. 5 has a greater bulging degree, and the elastic shell 330 has a greater deformation than that in the initial state. In addition, the deformation is within a deformation capability range of the elastic shell 330, and may be pre-designed based on an actual application scenario.

In this implementation, the elastic shell 330 is enabled to have a greater deformation, so that a rebound force generated by the elastic shell 330 due to the deformation may be used to press the first cover 310 and the second cover 320 tightly between the heat sink 410 and the electronic component 420. For example, when the thermal pad is placed in a manner shown in (A) in FIG. 5, the rebound force generated by the elastic shell 330 due to the deformation may be used to press the first cover 310 tightly below the heat sink 410 shown in the figure, and press the second cover 320 tightly above the electronic component 420 shown in the figure. In this way, heat of the electronic component 420 may be transferred to the heat sink 410 through the second cover 320, the liquid metal 340, and the first cover 310 in sequence. Alternatively, when the thermal pad is placed in a manner shown in (B) in FIG. 5, the rebound force generated by the elastic shell 330 due to the deformation may be used to press the first cover 310 tightly above the electronic component 420 shown in the figure, and press the second cover 320 tightly below the heat sink 410 shown in the figure. In this way, heat of the electronic component 420 may be transferred to the heat sink through the first cover 310, the liquid metal 340, and the second cover 320 in sequence.

For example, after the deformation of the elastic shell 330 is fixed, a thickness of the elastic shell 330 may be determined based on a force bearing capability of the electronic component 420. For example, if the elastic shell 330 needs to be compressed to a specific deformation degree, a greater thickness of the elastic shell 330 indicates a greater rebound force generated when the elastic shell 330 is compressed to the deformation. On the contrary, a smaller thickness of the elastic shell 330 indicates a smaller rebound force generated when the elastic shell 330 is compressed to the deformation. Therefore, when the deformation degree of the elastic shell 330 is fixed, if the force-bearing capability of the electronic component 420 used for pressing is greater, the elastic shell 330 can be designed to be thicker, and if the force-bearing capability of the electronic component 420 used for pressing is smaller, the elastic shell 330 can be designed to be thinner.

Further, for example, the assembly manner shown in (A) in FIG. 5 is used as an example. It is assumed that a rebound force applied by the elastic shell 330 to the second cover 320 is first pressure. The first pressure is transmitted to the electronic component 420 below shown in the figure through the second cover 320 and then is converted into second pressure. To ensure that the electronic component 420 is pressed against the second cover 320 and is not damaged by the second cover 320, the second pressure needs to be not less than minimum tolerable pressure of the electronic component 420 and not greater than maximum tolerable pressure of the electronic component 420. Therefore, in an example, after a shape and a deformation degree of the elastic shell 330 are designed, a first thickness corresponding to the second pressure that is the minimum tolerable pressure of the electronic component 420 and a second thickness corresponding to the second pressure that is the maximum tolerable pressure of the electronic component 420 may be obtained through testing by changing a thickness of the elastic shell 330. Therefore, during mass production of the thermal pad, the thickness of the elastic shell 330 may be selected as a thickness that is not less than the first thickness and not greater than the second thickness. For example, the thickness of the elastic shell 330 may be selected as an average thickness of the first thickness and the second thickness, to be compatible with a pressure deviation caused by a preparation tolerance of the electronic component 420.

Further, for example, it is considered that when the thickness of the elastic shell 330 is excessively small, the elastic shell 330 may not provide a rebound force that can press the electronic component 420 rightly (which may be understood as close contact). Therefore, as shown in FIG. 6, when the thickness of the elastic shell 330 is less than the first thickness, the thermal pad may further include an elastic structure 360. The elastic structure 360 is connected between the first cover 310 and the second cover 320. The first thickness may be considered as a thickness at which a maximum rebound force that can be provided by the elastic shell 330 can be just used to press the electronic component 420 tightly. The thickness may be set by a person skilled in the art based on experience, or may be obtained through an experiment test. This is not specifically limited.

It may be understood that when the thermal pad is not compressed between the heat sink 410 and the electronic component 420, both the elastic shell 330 and the elastic structure 360 are in a loose state, or are in a slightly compressed state to ensure that the liquid metal is fully filled. However, when the thermal pad is compressed between the heat sink 410 and the electronic component 420, both the elastic shell 330 and the elastic structure 360 are in a deeply compressed state. In the deeply compressed state, a rebound force of the elastic shell 330 and a rebound force of the elastic structure 360 are jointly applied to the electronic component 420. The rebound force of the elastic structure 360 is used to supplement an insufficient elastic force of the elastic shell 330, to implement close contact between the second cover 320 and the electronic component 420, thereby implementing effective heat conduction between the second cover 320 and the electronic component 420.

Further, it may be understood that a greater compression degree of the elastic shell 330 results in a smaller thickness of the thermal pad. It is found through research that thermal resistance of the thermal pad is positively correlated with the thickness of the thermal pad. Therefore, to further reduce the thermal resistance of the thermal pad, the thermal pad may be compressed as much as possible after the thermal pad is placed between the heat sink 410 and the electronic component 420, until pressure provided by the elastic shell 330 (or further including the elastic structure 360) for the electronic component 420 reaches the maximum tolerable pressure of the electronic component 420, or pressure provided by the elastic shell 330 (or further including the elastic structure 360) for the heat sink 410 reaches the maximum tolerable pressure of the heat sink 410. In this state, the thickness of the thermal pad reaches a maximum bearing capability of the electronic component 420 or the heat sink 410, so that the thickness of the thermal pad is a minimum feasible thickness, the thermal resistance of the thermal pad reaches a minimum, and the heat conduction performance of the thermal pad is the best.

It should be noted that compressing the thickness of the thermal pad to the minimum feasible thickness is merely an optional implementation. In an actual operation, the thickness of the thermal pad may be compressed to any thickness between the initial thickness and the minimum feasible thickness. This may be specifically set based on an actual requirement, and is not limited.

### 3. Liquid metal

It may be understood that the liquid metal refers to a metal or an alloy that is in a liquid state and has fluidity at a room temperature or at a low heating temperature, and a melting point of the liquid metal usually does not exceed a melting temperature (660.37°C) of aluminum. Examples of some liquid metals include but are not limited to the following metals or alloys: mercury, cesium, gallium, rubidium, potassium, sodium, indium, lithium, tin, bismuth, thallium, cadmium, lead, zinc, antimony, magnesium, aluminum, and the like.

Filling the liquid metal into the elastic shell through the thermal pad shown in FIG. 3 can not only implement good heat conduction effect by using high thermal conductivity of the liquid metal, but also implement compression on the thermal pad during assembly of the thermal pad by using compressibility of the elastic shell, to reduce the thickness of the thermal pad as much as possible. This reduces the thermal resistance of the thermal pad and further improves heat conduction effect of the thermal pad. In this way, efficiently conducing out heat of the electronic component through the thermal pad helps effectively dissipate heat of the electronic component.

The foregoing describes the structure of the thermal pad. The following describes a heat dissipation apparatus assembled with the thermal pad.

FIG. 7 illustrates a structure of a heat dissipation apparatus according to this application. The heat dissipation apparatus includes a heat sink 410, an electronic component 420, and the thermal pad described in any one of the foregoing embodiments. The thermal pad is compressed between the heat sink 410 and the electronic component 420. For example, as shown in both FIG. 3 and FIG. 7, when the thermal pad is not used, the elastic shell 330 has a first deformation. However, when the thermal pad is compressed between the heat sink 410 and the electronic component 420, the elastic shell 330 has a second deformation. A bulging degree of the elastic shell 330 in the second deformation is greater than a bulging degree of the elastic shell 330 in the first deformation, and the second deformation is greater than the first deformation. In this way, a rebound force of the elastic shell 330 in the second deformation can be used to press the first cover 310 toward the heat sink 410 and press the second cover 320 toward the electronic component 420, to implement effective heat conduction between the heat sink 410 and the electronic component 420.

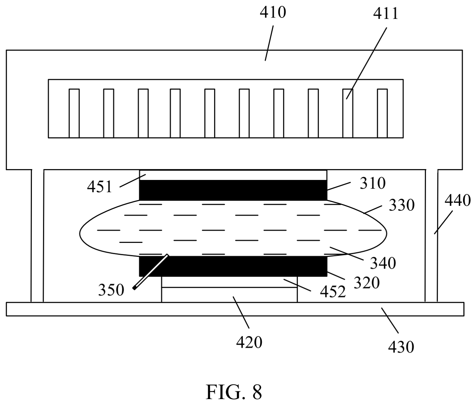

It may be understood that the heat sink 410 may be a heat sink with any one or more heat dissipation manners, for example, may be a liquid-cooled heat sink, an air-cooled heat sink, a semiconductor cooler, or a heat pipe heat sink. For example, FIG. 8 is a diagram of a structure of a liquid-cooled heat sink according to this application. The liquid-cooled heat sink has a hollow cavity, and a plurality of finned tubes 411 are disposed in the hollow cavity. Salt water or low-temperature water is introduced into the finned tubes 411, to cool air in the hollow cavity.

In an optional implementation, still refer to FIG. 7. The heat dissipation apparatus may further include a first heat dissipation layer 451. The first heat dissipation layer 451 is disposed between the first cover 310 and the heat sink 410, and is configured to implement heat dissipation from the first cover 310 to the heat sink 410. For example, the first heat dissipation layer 451 may be made of a heat conducting phase change material, thermal gel, solder paste, silicone grease, or another type of ultra-thin thermal pad. The heat conducting phase change material, thermal gel, and solder paste are materials with good thermal conductivity, and are used as the first heat dissipation layer 451, so that heat conduction effect from the first cover 310 to the heat sink 410 can be improved. In addition, although the silicone grease or another type of ultra-thin thermal pad may not be an ideal material with good thermal conductivity, the silicone grease or another type of ultra-thin thermal pad may be made particularly thin to reduce thermal resistance of the first heat dissipation layer 451. In this way, heat dissipation effect from the first cover 310 to the heat sink 410 can also be improved.

In an optional implementation, still refer to FIG. 7. The heat dissipation apparatus may further include a second heat dissipation layer 452. The second heat dissipation layer 452 is disposed between the second cover 320 and the electronic component 420, and is configured to implement heat dissipation from the electronic component 420 to the second cover 320. For example, the second heat dissipation layer 452 may be made of a non-metal material with good thermal conductivity or heat dissipation, such as silicone grease, a heat conducting phase change material, thermal gel, or another type of ultra-thin thermal pad. In this way, thermal resistance of the second heat dissipation layer 452 can be reduced, heat transfer effect from the electronic component 420 to the second cover 320 can be improved, and a risk of interference to the electronic component 420 can be reduced by avoiding use of a metal heat dissipation material.

It may be understood that, in addition to implementing a heat dissipation function between upper and lower layer of components, the first heat dissipation layer 451 or the second heat dissipation layer 452 may further exist as a fastener. For example, the first cover 310 and the heat sink 410 are fastened to each other through solder paste soldering or silicone grease filling (or another type of first heat dissipation layer 451), and the second cover 320 and the electronic component 420 are fastened to each other through silicone grease filling (or another type of second heat dissipation layer 452). However, this is merely an optional implementation. In actual assembly, the first cover 310 and the heat sink 410 or the second cover 320 and the heat sink 420 may alternatively be fastened to each other in another manner, for example, fastened to each other through threaded screw thread fitting.

In an optional implementation, still refer to FIG. 7. The heat dissipation apparatus may further include a circuit board 430. The circuit board 430 is configured to carry the electronic component 420. For example, the electronic component 420 may be fastened to the circuit board 430. For example, the circuit board 430 may be a printed circuit board (printed circuit board, PCB), a ceramic circuit board, a circuit board, an aluminum substrate, a high-frequency board, a thick copper board, an impedance board, or the like.

In a further optional implementation, the circuit board 430 may be further fastened to the heat sink 410. A fastening manner may include but is not limited to: a screw connection, a spline connection, a wedge pin connection, soldering, riveting, or tight-fit tenon. For example, the screw connection is used as an example. Still refer to FIG. 7. The heat dissipation apparatus may further include a screw 440. The screw 440 is fastened to the heat sink 410, for example, may be integrally formed with the heat sink 410. Correspondingly, a screw hole may be further provided on a position that is on the circuit board 430 and that is opposite to the screw 440. The heat sink 410 is fastened to the circuit board 430 by screwing the screw 440 into the screw hole, to clamp the electronic component 420 carried on the circuit board 430 and the thermal pad between the circuit board 430 and the heat sink 410, so as to avoid movement.

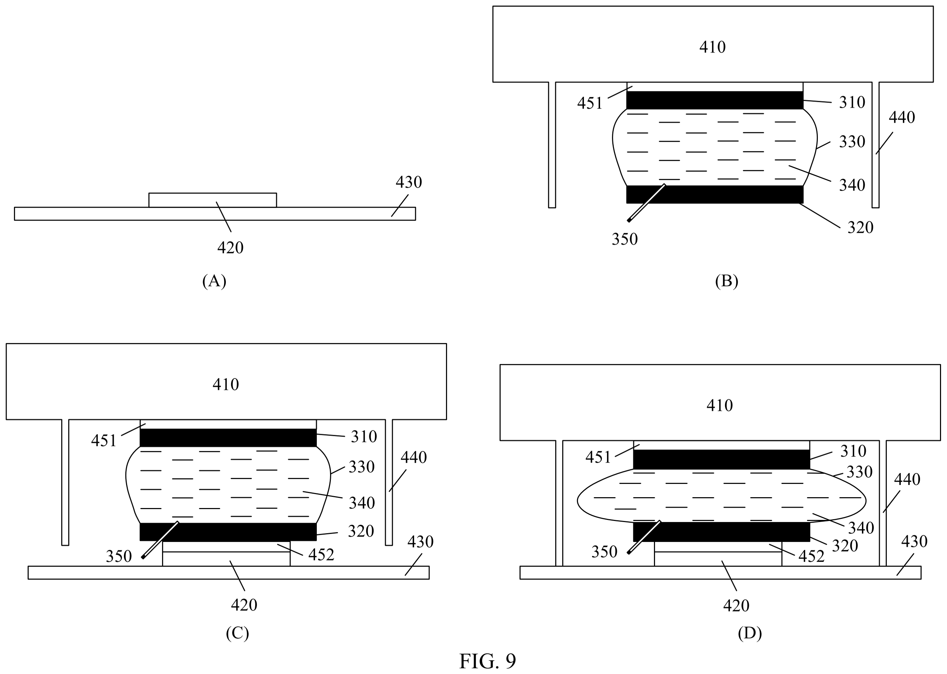

Optionally, for example, the first heat dissipation layer 451 is made of solder paste, and the second heat dissipation layer 452 is made of silicone grease. FIG. 9 illustrates an assembly process of a heat dissipation apparatus according to this application. The assembly process uses assembly of one thermal pad as an example, and mainly includes the following steps.

Step 1: As shown in (A) in FIG. 9, the electronic component 420 is fastened to the circuit board 430.

Step 2: As shown in (B) in FIG. 9, the first cover 310 of the thermal pad and the heat sink 410 are soldered together by using the solder paste.

Step 2: As shown in (C) in FIG. 9, after the screw 440 integrally formed with the heat sink 410 is aligned with the screw hole on the circuit board 430, the circuit board 430 and the heat sink 410 are assembled together, and the silicone grease is filled between the second cover 320 of the thermal pad and the electronic component 420.

Step 4: As shown in (D) in FIG. 9, the screw 440 is screwed into the screw hole on the circuit board 430, and is further tightened, so that the thermal pad is squeezed, the elastic shell 330 on the thermal pad bulges around, the elastic shell 330 is compressed, and a thickness of the thermal pad is reduced. The compressed elastic shell 330 tightly presses the first cover 310 below the heat sink 410 shown in the figure, and presses the second cover 320 above the electronic component 420 shown in the figure.

For example, a thickness and a shape of the elastic shell 330 are designed based on the foregoing description part of the thermal pad, and a thickness of the elastic shell 330 in this application may be compressed by about 50%. In this way, even if the screw 440 and the electronic component 420 have a specific height tolerance due to an existing preparation process, and a gap between the electronic component 420 and the heat sink 410 is approximately 1 mm to 2 mm, the gap may be reduced to 0.5 mm to 1 mm through the elastic shell 330 in an assembly process. In this way, the thickness of the thermal pad is greatly reduced, the thermal resistance of the thermal pad is effectively reduced, and heat conduction effect is improved. For example, it is found through research that, compared with an existing silicone-based thermal pad with a thickness of 1 mm to 2 mm, the thermal pad provided in this application can improve heat conduction efficiency by at least 22%, thereby greatly improving heat conduction effect of the thermal pad.

It should be noted that the foregoing content is described by using an example in which one electronic component 420 is carried on the circuit board 430. In some scenarios, the circuit board 430 may further carry a plurality of electronic components 420 at the same time. For example, in development of autonomous driving, as required computing power increases, a vehicle is likely to work together with a plurality of electronic components (for example, a vehicle-mounted chip). The plurality of electronic components may be distributed on a single-layer circuit board in a planar array form, or may be distributed on a multi-layer circuit board in a three-dimensional array form. In this scenario, each electronic component may correspond to one thermal pad.

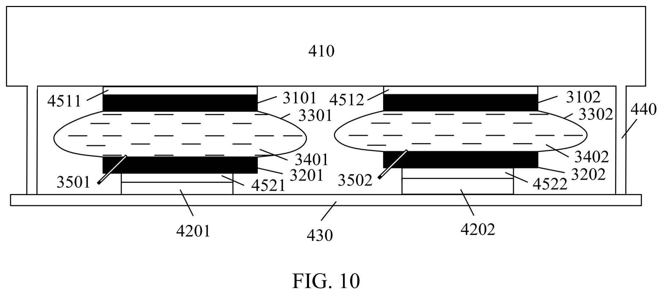

For example, refer to FIG. 10. An example in which two electronic components 4201 and 4202 are carried on a single-layer circuit board 430 is used. The two electronic components 4201 and 4202 may be connected to the heat sink 410 through corresponding thermal pads for heat dissipation. For example, the electronic component 4201 is connected to the heat sink 410 for heat dissipation through a corresponding thermal pad (including a first cover 3101, a second cover 3201, an elastic shell 3301, and a liquid metal 3401) a corresponding first heat dissipation layer 4511, and a corresponding second heat dissipation layer 4521, and the electronic component 4202 is connected to the heat sink 410 for heat dissipation through a corresponding thermal pad (including a first cover 3102, a second cover 3202, an elastic shell 3302, and a liquid metal 3402), a corresponding first heat dissipation layer 4512, and a corresponding second heat dissipation layer 4522.

It may be understood that, due to impact of a preparation tolerance, thicknesses of the electronic components 4201 and 4202 may be not the same. For example, the electronic component 4202 shown in the figure has a greater thickness than the electronic component 4201. However, as the used thermal pad is elastic, a deviation in thickness may be eliminated by compressing the thermal pad to different thicknesses. The thinner the thermal pad is compressed, the smaller the thermal resistance in the heat transfer process is, and the more easily and quickly the heat of the electronic component is transferred to the heat sink 410 above.

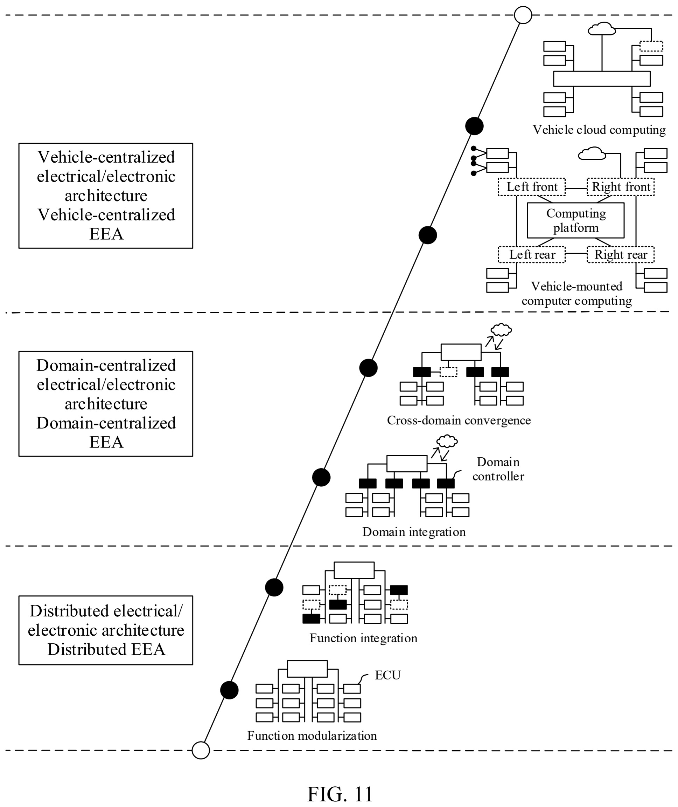

In addition, the foregoing electronic component may be any device or device combination having a processing capability. For example, in the field of intelligent driving, the electronic component may be an electronic control unit (electronic control unit, ECU) that is in a vehicle and that is configured to implement an autonomous driving function. The vehicle may be a vehicle in any electrical/electronic architecture (electrical/electronic architecture, EEA) architecture that currently exists or that may evolve in the future. For example, refer to FIG. 11. FIG. 11 illustrates a flowchart of evolution of an in-vehicle EEA.

In an example, the vehicle may be a conventional distributed electrical/electronic architecture (distributed EEA). The distributed EEA evolves from a function modularization phase to a function integration phase. In the function modularization phase, a single ECU is usually responsible for controlling only a single function. For example, light on the vehicle corresponds to one ECU, a door corresponds to one ECU, and a keyless system corresponds to one ECU. In the function integration phase, a single ECU may be responsible for a plurality of function units. For example, the door and the keyless system are controlled by one ECU.

In a distributed EEA vehicle, an electronic component may be an ECU responsible for implementing a single function or responsible for implementing a plurality of functions, for example, a light controller, a vehicle door controller, a keyless system, or an integrated controller configured to control a vehicle door and the keyless system.

In another example, the vehicle may be a domain-centralized electrical/electronic architecture (domain-centralized EEA) that is commonly used currently. The domain-centralized EEA evolves from a domain integration phase to a cross-domain convergence phase. In the domain integration phase, the entire vehicle is divided into a plurality of domains based on functions, for example, a power domain, a chassis domain, a vehicle body domain, a cockpit domain, and an autonomous driving domain. A domain controller of each domain is connected to all ECUs in the domain. In the cross-domain convergence phase, a plurality of domain controllers are converged across domains, and are uniformly controlled by a cross-domain control unit. For example, in a cross-domain convergence solution, the power domain, the chassis domain, and the vehicle body domain are combined into a vehicle control domain.

In a domain-centralized EEA vehicle, an electronic component may be a domain controller of a single functional domain, a domain controller of cross-domain convergence, or an ECU in any domain, for example, a power domain controller, a chassis domain controller, a vehicle body domain controller, a cockpit domain controller, an autonomous driving domain controller, a vehicle domain controller, or an ECU managed by the vehicle domain controller.

In another example, the vehicle may be a vehicle-centralized electrical/electronic architecture (vehicle-centralized EEA) that may evolve in the future. The vehicle-centralized EEA is expected to evolve from an in-vehicle computer computing phase to a vehicle cloud computing phase. In the in-vehicle computer computing phase, a functional domain is further upgraded to a more general in-vehicle computer computing platform, and enters from the functional domain to a zone domain (for example, a left front domain, a left rear domain, a right front domain, and a right rear domain), and a corresponding zonal control unit (zonal control unit, ZCU) is disposed in each zone. In the vehicle cloud computing phase, some or all functions of the vehicle are further transferred to a cloud, sensors and actuators on the vehicle can be defined and controlled by software, and components on the vehicle gradually become standard components. This further simplifies an in-vehicle architecture, and completely implements software-defined vehicle functions.

In a vehicle-centralized EEA vehicle, an electronic component may be an in-vehicle computer computing platform, a ZCU in any one or more zones, an ECU in the ZCU, a software-defined ECU, or the like.

It should be understood that the foregoing content describes a possible case of the electronic component only by using autonomous driving in the vehicle as an example. The electronic component is not limited to an electronic component in the vehicle in this application. For example, in some other scenarios, the electronic component may alternatively be a component that has a processing function in a terminal device, a network device, a server, an industrial device, an intelligent furniture device, a smart grid, or the like.

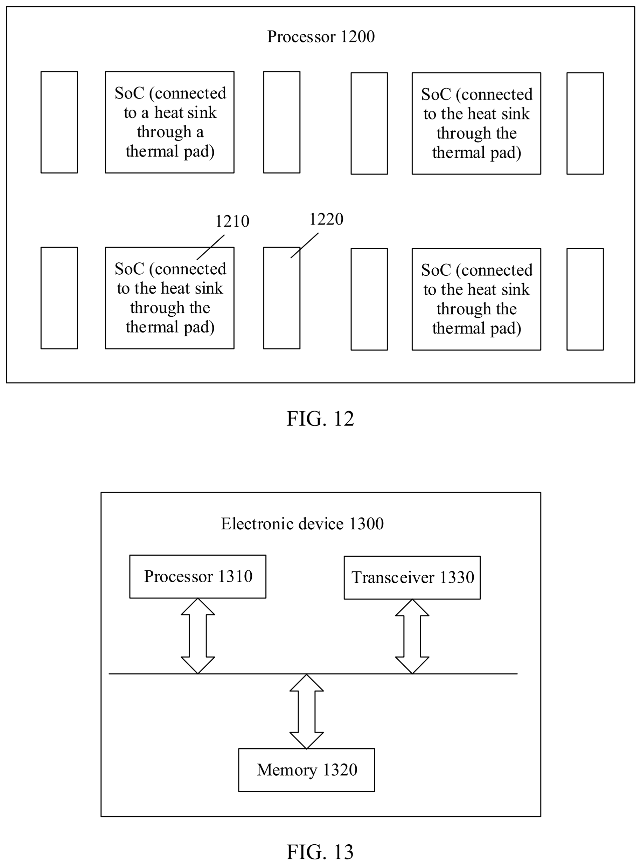

Based on the structure and the functional principle of the thermal pad described above, this application may further provide a processor. FIG. 12 is a diagram of a possible functional framework of a processor according to this application. The processor 1200 may be, for example, an integrated chip, and may include one or more processing units 1210 and a peripheral circuit 1220 disposed around each processing unit 1210. Any processing unit 1210 may be connected to a heat sink through the thermal pad in any one of the foregoing embodiments.

In some examples, the processing unit 1210 may be an application processor (application processor, AP), a modem processing unit, a graphics processing unit (graphics processing unit, GPU), an image signal processor (image signal processor, ISP), a video codec unit, a digital signal processor (digital signal processor, DSP), a baseband processing unit, and/or a neural-network processing unit (neural-network processing unit, NPU), or may be a field programmable gate array (field programmable gate array, FPGA), an application-specific chip (application-specific integrated circuit, ASIC), a SoC, a microcontroller unit (microcontroller unit, MCU), a programmable controller (programmable logic device, PLD), or another device having a processing capability.

In some examples, the peripheral circuit 1220 may include but is not limited to a general unit, an accelerator unit, an input/output control unit, an interface unit, an external buffer, an internal buffer, and the like. The memory (for example, an internal memory and an external buffer) may be a volatile memory or a non-volatile memory, or may include both a volatile memory and a non-volatile memory. This is not specifically limited.

It may be understood that the functional framework shown in FIG. 12 does not constitute a specific limitation on the processor. In some other embodiments of this application, the processor may include more or fewer components than those shown in the figure, or combine some components, or split some components, or have different component arrangements, or have different position arrangements. This is not specifically limited.

Based on the structure and function principle of the processor described above, this application may further provide an electronic device. FIG. 13 is a diagram of a possible functional framework of an electronic device according to this application. The electronic device 1300 may include a processor 1310 and a memory 1320, or may further include a transceiver 1330. The processor 1310 may be the foregoing processor 1200. The processor 1310 and elements around the processor 1310, for example, the memory 1320 and the transceiver 1330, may be connected through a bus, for example, through an I/O bus. The processor 1310 may read and write data in the memory 1320 through the I/O bus.

The memory 1320 may be specifically an internal memory, and may be configured to store computer-executable program code. The executable program code includes instructions. The internal memory may include a program storage area and a data storage area. The program storage area may store an operating system, an application required by at least one function (for example, a call function or a time setting function), and the like. The data storage area may be used to store data (such as a phone book and world clock) and the like created when the electronic device is used. In addition, the internal memory may include a high-speed random access memory, and may further include a non-volatile memory, for example, at least one magnetic disk storage device, a flash storage device, or a universal flash storage (universal flash storage, UFS). The processor 1310 performs various function applications of the electronic device 1300 and data processing by running the instructions stored in the internal memory.

In some scenarios, the electronic device 1300 may further include an external memory interface. The electronic device 1300 may be connected to an external memory card, for example, a micro SD card, through the external memory interface, to expand a storage capability of the electronic device 1300. For example, the external memory card communicates with the processor 1310 through the external memory interface, to implement a data storage function.

The transceiver 1330 may enable the electronic device 1300 to perform wireless communication with the outside. The transceiver 1330 may provide wireless communication solutions such as a wireless local area network (wireless local area network, WLAN) (for example, a wireless fidelity (wireless fidelity, Wi-Fi) network), Bluetooth (Bluetooth, BT), a global navigation satellite system (global navigation satellite system, GNSS), frequency modulation (frequency modulation, FM), a near field communication (near field communication, NFC) technology, and an infrared (infrared, IR) technology. The transceiver 1330 may be one or more components integrated with at least one communication processing module. The transceiver 1330 receives an electromagnetic wave through an antenna, performs frequency modulation and filtering processing on an electromagnetic wave signal, and sends a processed signal to the processor 1310. The transceiver 1330 may further receive a to-be-sent signal from the processor 1310, perform frequency modulation and amplification on the signal, and convert the signal into an electromagnetic wave through the antenna for radiation.

In some examples, the electronic device may be a terminal device, for example, a mobile phone, a computer, a smartwatch, a virtual reality device, a projector, or a smart camera. Alternatively, the electronic device may be a means of transportation, for example, a car, an airplane, a ship, an uncrewed aerial vehicle, a subway, a train, or a truck. Alternatively, the electronic device may be a computer, for example, a desktop computer, a palm computer, a laptop computer, or a computer cluster. Alternatively, the electronic device may be a network device, for example, a gateway, a switch, a router, a firewall, a bridge, a wireless access point, a modem, or an optical fiber transceiver.

In addition, the functional framework of the electronic device shown in FIG. 13 is merely an example. In some other embodiments of this application, the electronic device may include more or fewer components than those shown in the figure, or combine some components, or split some components, or have different component arrangements. The components shown in the figure may be implemented by hardware, software, or a combination of software and hardware.

In embodiments of this application, unless otherwise stated or if there is a logic conflict, terms and/or descriptions in different embodiments are consistent and may be mutually referenced, and technical features in different embodiments may be combined into a new embodiment based on an internal logical relationship thereof.

In this application, the "thickness" does not refer to an absolute thickness, and may have an engineering error. The "shape" does not refer to an absolutely uniform shape, and may have a specific engineering error. "At least one" means one or more, and "a plurality of" means two or more. "And/or" describes an association relationship between associated objects, and indicates that three relationships may exist. For example, A and/or B may indicate the following three cases: Only A exists, both A and B exist, and only B exists, where A and B may be in a singular form or a plural form. "At least one of the following items (pieces)" or a similar expression thereof indicates any combination of these items, including a single item (piece) or any combination of a plurality of items (pieces). For example, at least one of a, b, or c may indicate a, b, c, a and b, a and c, b and c, or a, b, and c, where a, b, and c may be singular or plural. In text descriptions of this application, the character "/" generally indicates an "or" relationship between associated objects. In a formula of this application, the character "/" indicates a "division" relationship between associated objects. In addition, in this application, the term "for example" indicates giving an example, an illustration, or a description. Any embodiment or design solution described as an "example" in this application should not be explained as being more preferred or having more advantages than another embodiment or design solution. Alternatively, it may be understood as that the word "example" is used to present a concept in a specific manner, and does not constitute a limitation on this application.

It may be understood that various numbers in this application are merely used for differentiation for ease of description, and are not used to limit the scope of embodiments of this application. Sequence numbers of the foregoing processes do not mean an execution sequence, and the execution sequence of the processes should be determined based on functions and internal logic of the processes. The terms "first", "second", and the like are used to distinguish between similar objects without having to describe a specific order or sequence. In addition, the terms "include", "have", or any variant thereof are intended to cover non-exclusive inclusion, for example, include a series of steps or units. A method, system, product, or device is not necessarily limited to those steps or units expressly listed, but may include other steps or units not expressly listed or inherent to such a process, method, product, or device.

## Claims

1. A thermal pad, comprising a first cover, a second cover, an elastic shell, and liquid metal, wherein
the elastic shell is bent and closed into a tubular structure, the first cover and the second cover are respectively mounted at two ends of the tubular structure to form a closed cavity, and the closed cavity is configured to accommodate the liquid metal.

2. The thermal pad according to claim 1, wherein the first cover and the second cover are metal covers.

3. The thermal pad according to claim 1 or 2, wherein the elastic shell is made of beryllium copper, phosphor copper, thin steel, or rubber.

4. The thermal pad according to any one of claims 1 to 3, wherein when a thickness of the elastic shell is less than a first thickness, the thermal pad further comprises an elastic structure, and the elastic structure is connected between the first cover and the second cover.

5. The thermal pad according to any one of claims 1 to 4, wherein the thermal pad is compressed between a heat sink and an electronic component, and pressure applied by the thermal pad to the electronic component is not less than minimum tolerable pressure of the electronic component and is not greater than maximum tolerable pressure of the electronic component.

6. The thermal pad according to any one of claims 1 to 5, wherein the thermal pad further comprises a mouse-tail tube, the mouse-tail tube is internally hollow and penetrates the first cover or the second cover, one end of the mouse-tail tube extends into the closed cavity, and the other end of the mouse-tail tube is sealed after the liquid metal is guided into the closed cavity.

7. A heat dissipation apparatus, comprising a heat sink, an electronic component, and the thermal pad according to any one of claims 1 to 6, wherein
the thermal pad is compressed between the heat sink and the electronic component, and a rebound force of the elastic shell is used to press the first cover toward the heat sink and press the second cover toward a surface of the electronic component.

8. The heat dissipation apparatus according to claim 7, wherein the heat dissipation apparatus further comprises a first heat dissipation layer, and the first heat dissipation layer is disposed between the first cover and the heat sink.

9. The heat dissipation apparatus according to claim 8, wherein the first heat dissipation layer is made of silicone grease, a heat conducting phase change material, thermal gel, or solder paste.

10. The heat dissipation apparatus according to any one of claims 7 to 9, wherein the heat dissipation apparatus further comprises a second heat dissipation layer, and the second heat dissipation layer is disposed between the second cover and the electronic component.

11. The heat dissipation apparatus according to claim 10, wherein the second heat dissipation layer is made of silicone grease, a heat conducting phase change material, or thermal gel.

12. The heat dissipation apparatus according to any one of claims 7 to 11, wherein the heat dissipation apparatus further comprises a circuit board, and the circuit board is configured to carry the electronic component.

13. The heat dissipation apparatus according to claim 12, wherein the circuit board is fastened to the heat sink through a screw.

14. An electronic device, comprising the heat dissipation apparatus according to any one of claims 7 to 13.
